# EUROPÄISCHE PATENTSCHRIFT

(11) **EP 3 403 271 B1**
(45) Veröffentlichungstag und Bekanntmachung des Hinweises auf die Patenterteilung: **23.10.2019**
(21) Anmeldenummer: 17702822.2
(22) Anmeldetag: 27.01.2017
(51) Int. Cl.: H01H 33/59, H01H 9/54

(54) **VORRICHTUNG ZUM SCHALTEN EINES GLEICHSTROMS IN EINEM POL EINES GLEICHSPANNUNGSNETZES**
DEVICE FOR SWITCHING A DC CURRENT IN A POLE OF A DC VOLTAGE NETWORK
DISPOSITIF DE COMMUTATION D'UN COURANT CONTINU DANS UN PÔLE D'UN RÉSEAU DE TENSION CONTINUE

(30) Priorität: 22.02.2016 DE 102016202661
(43) Veröffentlichungstag der Anmeldung: 21.11.2018
(73) Patentinhaber: Siemens Aktiengesellschaft, 80333 München (DE)
(72) Erfinder: KRISHNAN, Jaganath, 90478 Nürnberg (DE); GUELDNER, Henry, 01809 Heidenau (DE); HANDT, Karsten, 92348 Berg (DE); NIELEBOCK, Sebastian, 91301 Forchheim (DE)
(86) Internationale Anmeldenummer: PCT/EP2017/051787
(87) Internationale Veröffentlichungsnummer: WO 2017/144234

(56) Entgegenhaltungen:
- WO-A1-2011/141055
- WO-A1-2013/131582
- WO-A1-2014/094847

## Beschreibung

Die Erfindung betrifft eine Vorrichtung zum Schalten eines Gleichstromes in einem Pol eines Gleichspannungsnetzzweiges.

Der weltweit steigende Energiebedarf und die gleichzeitig gewünschte Verringerung des CO₂-Ausstoßes machen erneuerbare Energien immer attraktiver. Quellen erneuerbarer Energien sind beispielsweise seeseitig aufgestellte Windkraftanlagen oder aber Photovoltaikkraftanlagen in sonnenreichen Wüstenbereichen. Um die so erzeugte Energie ökonomisch nutzen zu können, kommt der Anbindung der erneuerbaren Energiequellen an ein Landversorgungsnetz eine immer größere Bedeutung zu. Vor diesem Hintergrund wird die Errichtung und der Betrieb eines vermaschten Gleichspannungsnetzes immer stärker diskutiert. Voraussetzung hierfür ist jedoch, dass Kurzschlussströme, die in einem solchen vermaschten Gleichspannungsnetz auftreten können, schnell und zuverlässig abgeschaltet werden können. Hierzu sind jedoch Gleichspannungsschalter erforderlich, die bisher am Markt nicht verfügbar sind. Aus dem Stand der Technik sind unterschiedliche Konzepte für einen solchen Gleichspannungsschalter bekannt.

In der WO 2011/057675 A1 ist ein Gleichspannungsschalter beschrieben, der einen Betriebsstrompfad mit einem mechanischen Schalter sowie einen Abschaltzweig aufweist, der dem Betriebsstrompfad parallel geschaltet ist. In dem Abschaltzweig ist eine Reihenschaltung von Leistungshalbleiterschaltern angeordnet, denen jeweils eine Freilaufdiode gegensinnig parallel geschaltet ist. Die aus Leistungshalbleiterschalter und Freilaufdiode bestehenden Schalteinheiten sind antiseriell angeordnet, wobei die abschaltbaren Leistungshalbleiterschalter in Reihe angeordnet sind und für jeden Leistungshalbleiterschalter ein entsprechender Leistungshalbleiterschalter mit entgegen gesetzter Durchlassrichtung vorgesehen ist. Auf diese Art und Weise kann der Strom in beiden Richtungen im Abschaltzweig unterbrochen werden. Im Betriebsstrompfad ist neben dem mechanischen Schalter auch ein elektronischer Hilfsschalter in Reihe zum mechanischen Schalter angeordnet. Im Normalbetrieb fließt der Strom über den Betriebsstrompfad und somit über den elektronischen Hilfsschalter sowie über den geschlossenen mechanischen Schalter, da die Leistungshalbleiterschalter des Abschaltzweiges einen erhöhten Widerstand für den Gleichstrom darstellen. Zum Unterbrechen beispielsweise eines Kurzschlussstromes wird der elektronische Hilfsschalter in seine Trennstellung überführt. Hierdurch steigt der Widerstand im Betriebsstrompfad an, so dass der Gleichstrom in den Abschaltzweig kommutiert. Der schnelle mechanische Trennschalter kann daher stromlos geöffnet werden. Der über den Abschaltzweig geführte Kurzschlussstrom kann durch die Leistungshalbleiterschalter unterbrochen werden. Zur Aufnahme der im Gleichspannungsnetz gespeicherten und beim Schalten abzubauenden Energie sind Ableiter vorgesehen, die den Leistungshalbleiterschaltern des Abschaltzweiges jeweils parallel geschaltet sind.

In der DE 694 08 811 T2 ist ein Gleichspannungsschalter beschrieben, bei dem zwei mechanische Schalter in Reihe geschaltet sind. Die aus den beiden mechanischen Schaltern bestehende Reihenschaltung ist durch einen Ableiter sowie einen Kondensator vor hohen Überspannungen geschützt. Lediglich einem der mechanischen Schalter ist ein ein- und abschaltbarer Leistungshalbleiterschalter parallel geschaltet. Beim Öffnen der mechanischen Schalter entsteht ein Lichtbogen. Die an dem Lichtbogen abfallende Spannung zündet den Leistungshalbleiterschalter, wodurch der parallele geöffnete mechanische Schalter kurzgeschlossen wird. Der Lichtbogen erlischt. Der über den Leistungshalbleiterschalter geführte Strom kann nun durch entsprechende Ansteuerung des Leistungshalbleiters unterbrochen werden.

Die WO 2011/141055 offenbart einen Gleichspannungsschalter, der seriell in einen Pol eines Hochspannungsgleichstromnetzes geschaltet werden kann. Der Gleichspannungsschalter besteht aus einem mechanischen Schalter in Reihe zu einem Leistungshalbleiterschalter, dem wieder eine gegensinnige Freilaufdiode parallel geschaltet ist. Parallel zur Reihenschaltung aus Leistungshalbleiterschalter und mechanischem Schalter sind eine Reihenschaltung aus Spule und Kondensator, also ein LC-Zweig sowie ein Ableiter, geschaltet, der die über dem LC-Zweig abfallende Spannung begrenzt. Auch dem Leistungshalbleiterschalter ist ein Ableiter parallel geschaltet. Nach dem Öffnen des mechanischen Schalters wird der Leistungshalbleiterschalter mit der Eigenfrequenz des LC-Zweigs ein- und ausgeschaltet. Hierdurch werden eine Schwingung und schließlich ein Stromnulldurchgang im mechanischen Schalter erzeugt, so dass der entstehende Lichtbogen gelöscht werden kann.

Weitere Gleichspannungsschalter sind aus der WO 2014/094847 A1 und der WO 2013/131582 A1 bekannt. Die WO 2014/094847 A1 zeigt einen Gleichspannungsschalter mit einem ersten und zweiten Knotenpunkt zur seriellen Einbindung in einen Pol eines Gleichspannungsnetzes und mit einem zwischen dem ersten und zweiten Knotenpunkt angeordneten mechanischen Schalter sowie einem parallel zum mechanischen Schalter angeordneten Pulsstrommodul, das vier Halbleiterschalter umfasst, die als Brücke aus zwei Serien von je zwei der Halbleiterschalter geschaltet sind.

Aufgabe der Erfindung ist es, eine Vorrichtung der eingangs genannten Art bereitzustellen, mit der Fehlerströme in einem Gleichspannungsnetz zuverlässig und kostengünstig abgeschaltet werden können, wobei im Normalbetrieb gleichzeitig geringe Verluste entstehen.

Die Erfindung löst diese Aufgabe durch einen Gleichspannungsschalter mit einem ersten und zweiten Knotenpunkt zur seriellen Einbindung in einen Pol eines Gleichspannungsnetzes und einem dritten Knotenpunkt zum Anschluss an den anderen Pol des Gleichspannungsnetzes, weiterhin umfassend:
- einen zwischen dem ersten und zweiten Knotenpunkt angeordneten mechanischen Schalter,
- wenigstens ein zwischen dem ersten und zweiten Knotenpunkt parallel zum mechanischen Schalter angeordnetes Pulsstrommodul,
   wobei das Pulsstrommodul
- drei Modulknotenpunkte aufweist und der erste Modulknotenpunkt mit dem ersten Knotenpunkt und der zweite Modulknotenpunkt mit dem zweiten Knotenpunkt und der dritte Modulknotenpunkt mit dem dritten Knotenpunkt verbunden ist;
- vier Halbleiterschalter umfasst, die als Brücke aus zwei Serien von je zwei der Halbleiterschalter geschaltet sind, wobei die Potentialpunkte zwischen den Halbleiterschaltern der beiden Serien dem ersten und zweiten Modulknotenpunkt entsprechen und die äußeren Enden der beiden Serien von je zwei der Halbleiterschaltern paarweise zu einem vierten und fünften Modulknotenpunkt verbunden sind;
- einen Pulsstromkondensator umfasst, der parallel zu den beiden Serien von je zwei der Halbleiterschalter geschaltet ist;
- ein schaltbares Halbleiterelement zwischen dem fünften und dritten Modulknotenpunkt umfasst.

Die Halbleiterschalter sind dabei jeweils als wenigstens ein ein- und abschaltbarer Leistungshalbleiterschalter, also IGBT, IGCT, GTO oder dergleichen gestaltet, im Bedarfsfall mit jeweils gegensinnig paralleler Freilaufdiode. Selbstverständlich kann statt eines einzigen Leistungshalbleiterschalters auch eine synchron angesteuerte Reihenschaltung von Leistungshalbleiterschaltern eingesetzt werden. Die synchron angesteuerten Leistungshalbleiterschalter der Reihenschaltung verhalten sich dann genau wie ein einzelner Leistungshalbleiterschalter.

Ist der Gleichspannungsschalter betriebsbereit, kann beispielsweise ein Kurzschlussstrom unterbrochen werden. Im Normalbetrieb fließt ein Gleichstrom über den mechanischen Schalter nahezu verlustfrei. Im Fehlerfall öffnet der mechanische Schalter und zwei diagonal liegende Halbleiterschalter des Pulsstrommoduls werden angeschaltet. Durch die Trennung der Kontakte des mechanischen Schalters würde, wenn keine weiteren Maßnahmen vorgesehen wären werden, ein Lichtbogen gezogen. Das Anschalten der Halbleiterschalter unterdrückt aber die Entstehung eines Lichtbogens im Idealfall vollständig. Durch das Öffnen der Schalter wird ein Strompfad für die im Pulsstromkondensator gespeicherte Ladung geschaffen, wodurch im mechanischen Schalter ein Stromnulldurchgang passiert, wodurch der Lichtbogen vermieden oder gelöscht wird. Vorteilhaft kann durch den Gleichspannungsschalter ein Stromfluss in beiden Richtungen unterbrochen werden.

Die induktiv gespeicherte Energie des Gleichspannungsnetzwerks wird auf einer ersten Seite des Gleichspannungsschalters über einen Strompfad abgeleitet, der über einen der nicht eingeschalteten Halbleiterschalter und den Pulsstromkondensator zum dritten Knotenpunkt, d.h. zum anderen Pol des Gleichspannungsnetzwerks führt.

Vorteilhaft ist es, wenn der Gleichspannungsschalter eine Freilaufdiode zwischen dem dritten und dem ersten Knotenpunkt und eine weitere Freilaufdiode zwischen dem dritten und dem zweiten Knotenpunkt aufweist. Hierdurch wird vorteilhaft ein Abbau der induktiv gespeicherten Energie des Gleichspannungsnetzwerks erlaubt.

Zur Anpassung an Betriebsspannung und Betriebsstrom des Gleichspannungsnetzwerks kann der Gleichspannungsschalter mehrere der Pulsstrommodule umfassen. Diese sind dabei mit ihren ersten und zweiten Modulknotenpunkten in Serie geschaltet. Diese Serie selbst ist dann zwischen dem ersten und zweiten Knotenpunkt angeordnet. Die Anzahl der Pulsstrommodule richtet sich nach den jeweiligen Anforderungen. In jedem Fall müssen die Pulsstrommodule in der Lage sein, die anliegenden Spannungen aufzunehmen und auch hohe Kurzschlussströme sicher und ausreichend schnell abzuschalten.

Zweckmäßig umfasst der Gleichspannungsschalter in Serie zum Pulsstromkondensator einen Widerstand zur Ladestrombegrenzung. Als schaltbares Halbleiterelement im Pulsstrommodul wird bevorzugt ein Thyristor verwendet.

Zweckmäßig umfasst der Gleichspannungsschalter eine Steuereinrichtung, die ausgestaltet ist, für ein Trennen der Gleichspannungsleitung den mechanischen Schalter zu öffnen und zur Erzeugung eines dem Strom in der Gleichspannungsleitung gegengerichteten Strompulses zwei der vier Halbleiterschalter einzuschalten.

In einer Ausgestaltung wird die im Gleichspannungsnetz gespeicherte und beim Abschalten frei gesetzte Energie durch zweckmäßige Mittel zum Abbau der Schaltenergie abgebaut. Hierbei handelt es sich beispielsweise um nichtlineare Widerstände, beispielsweise um Ableiter, Varistoren oder dergleichen. Übersteigt die an ihnen abfallende Spannung eine Schwellenspannung, verhalten sich diese Bauteile wie ohmsche Widerstände, wobei sie die beim Schalten frei werdende Energie in thermische Energie umwandeln und an die Außenatmosphäre abgeben.

Zweckmäßigerweise ist der mechanische Schalter als schneller Schalter ausgebildet und zum Öffnen innerhalb von 1 ms bis 10 ms eingerichtet. Solche schnellen Schalter weisen eine geringe Schaltmasse auf, die beim Schalten bewegt werden muss. Darüber hinaus sind schnell ansprechende Antriebe, beispielsweise elektrodynamische Antriebe, erforderlich.

Gemäß einer weiteren Variante der Erfindung ist es zweckmäßig, dass die erfindungsgemäße Vorrichtung ebenfalls modular eingesetzt wird und somit als bipolares oder zweipoliges Bauteil in einer Reihenschaltung Verwendung findet.

Abschließend sei darauf hingewiesen, dass ein- und abschaltbare Leistungshalbleiterschalter hier zwar immer im Zusammenhang mit jeweils einer gegensinnig parallelen Freilaufdioden oder als rückwärts leitfähige Leistungshalbleiter offenbart sind. Dies ist jedoch in erster Linie dem Umstand geschuldet, dass abschaltbare Leistungshalbleiter wie IGBTs, IGCTs, GTOs oder dergleichen in der Regel immer mit einer gegensinnig parallelen Freilaufdiode im Markt vertrieben werden. Eine solche gegensinnige Freilaufdiode, dient dem Schutz des Leistungshalbleiterschalters, der gegenüber einer Spannung entgegengesetzt zu seiner Durchlassrichtung äußerst empfindlich ist. Die besagte Freilaufdiode ist jedoch nicht in allen hier gezeigten Fällen zwingend erforderlich. Diese Fälle sind dem Fachmann klar ersichtlich, so dass hierauf nicht im Einzelfall gesondert hingewiesen wird. Realisierungen der Erfindung, bei denen die gegensinnig parallel zum Leitungshalbleiterschalter angeordnete Freilaufdiode funktionsbedingt entfallen kann, sollen jedoch vom Schutzumfang mit umfasst sein.

Weitere zweckmäßige Ausgestaltungen und Vorteile der Erfindung sind Gegenstand der nachfolgenden Beschreibung von Ausführungsbeispielen unter Bezug auf die Figuren der Zeichnung, wobei gleiche Bezugszeichen auf gleich wirkende Bauteile verweisen und wobei
Figur 1 ein erstes Ausführungsbeispiel des erfindungsgemäßen Gleichspannungsschalters,
Figuren 2 und 3 das Ausführungsbeispiel gemäß Figur 1 mit unterschiedlichen Strompfaden bei der Abschaltung,
Figur 4 ein weiteres Ausführungsbeispiel der erfindungsgemäßen Vorrichtung,
Figur 5 ein Pulsstrommodul.

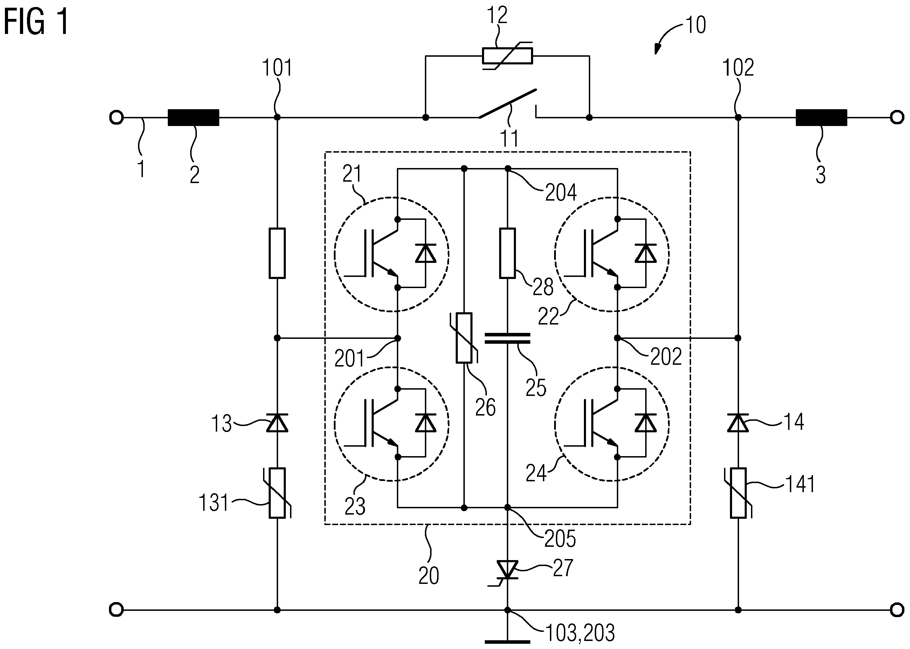

Figur 1 zeigt ein Ausführungsbeispiel des erfindungsgemäßen Gleichspannungsschalters 10, der mit einem ersten und zweiten Knotenpunkt 101, 102 seriell in einen Pol, also eine Leitung eines Gleichspannungsnetzes 1, geschaltet werden kann. Der Gleichspannungsschalter dient zum Unterbrechen eines Stromflusses in dem Pol des Gleichspannungsnetzes.

Der Gleichspannungsschalter 10 weist einen ersten Stromzweig zwischen dem ersten und zweiten Knotenpunkt 101, 102 auf, der keine Halbleiterelemente, sondern nur einen mechanischen Schalter 11 umfasst. Dadurch treten hier nur sehr geringe elektrische Verluste auf und im laufenden Betrieb wird der Stromfluss im Wesentlichen im ersten Stromzweig stattfinden. Optional ist im ersten Stromzweig ein Energieabsorber vorgesehen, beispielsweise ein Varistor 12. Dieser ist parallel zum mechanischen Schalter geschaltet.

Parallel dazu geschaltet, d.h. ebenfalls zwischen dem ersten und zweiten Knotenpunkt 101, 102, befindet sich ein zweiter Stromzweig. Der zweite Stromzweig erlaubt im normalen Betriebszustand keinen oder nur unerheblichen Stromfluss. Der zweite Stromzweig umfasst ein Pulsstrommodul 20. Das Pulsstrommodul 20 ist weiterhin auch mit einem dritten Knotenpunkt 103 des Gleichspannungsschalters 10 verbunden, der mit dem anderen Pol des Gleichspannungsnetzes 1 verbunden ist. Ausgehend vom dritten Knotenpunkt 103 führen zwei Freilaufdioden 13, 14 zum ersten bzw. zweiten Knotenpunkt 101, 102. Optional kann in Serie zu den Freilaufdioden 13, 14 jeweils ein weiterer Energieabsorber 131, 141 vorgesehen sein.

Das Pulsstrommodul 20 selbst umfasst einen ersten bis fünften Modulknotenpunkt 201...205. Dabei ist der erste Modulknotenpunkt 201 mit dem ersten Knotenpunkt 101 verbunden, der zweite Modulknotenpunkt 202 mit dem zweiten Knotenpunkt 102 und der dritte Modulknotenpunkt 203 mit dem dritten Knotenpunkt 103.

Das Pulsstrommodul 20 umfasst einen ersten bis vierten Halbleiterschalter 21...24, einen Pulsstromkondensator 25 und einen Thyristor 27. Optional ist ein Energieabsorber 26 und/oder ein Ladewiderstand 28 vorgesehen. Der Pulsstromkondensator weist beispielsweise eine Kapazität von 10 mF auf.

Der erste Modulknotenpunkt 201 ist der Potentialpunkt zwischen dem ersten und dritten Halbleiterschalter 21, 23, die gleichsinnig in Serie geschaltet sind. Der zweite Modulknotenpunkt 202 ist der Potentialpunkt zwischen dem zweiten und vierten Halbleiterschalter 22, 24, die ebenfalls gleichsinnig in Serie geschaltet sind. Die vom ersten bzw. zweiten Modulknotenpunkt 201, 202 abgewandten Anschlüsse des ersten und zweiten Halbleiterschalters 21, 22 sind zum vierten Modulknotenpunkt 204 zusammengeschlossen. Die vom ersten bzw. zweiten Modulknotenpunkt 201, 202 abgewandten Anschlüsse des dritten und vierten Halbleiterschalters 23, 24 sind zum fünften Modulknotenpunkt 205 zusammengeschlossen. Zwischen dem fünften Modulknotenpunkt 205 und dem dritten Modulknotenpunkt 203 ist der Thyristor 27 angeordnet, wobei er aus Sicht des dritten Modulknotenpunkts 203 sperrend angeordnet ist. Der Pulsstromkondensator 25 ist zwischen dem vierten und fünften Modulknotenpunkt 204, 205 angeordnet. Der optionale Ladewiderstand 28 ist seriell zum Pulsstromkondensator 25 angeordnet. Der Energieabsorber 26 ist zwischen dem vierten und fünften Modulknotenpunkt 204, 205 angeordnet, also parallel zum Pulsstromkondensator 25.

Im laufenden Betrieb fließt der Gleichstrom über den mechanischen Schalter 11. Der Pulsstromkondensator 25 ist durch Anschalten des Thyristors 27 aufgeladen. Wird nun ein Kurzschluss detektiert oder ist anderweitig eine Abschaltung des Stroms erforderlich, nimmt die in Figur 1 nicht dargestellte Steuerung des Gleichspannungsschalters 10 Schaltungen vor.

In einem ersten Schritt wird der mechanische Schalter 11 geöffnet und zwei diagonal liegende der vier Halbleiterschalter 21...24 angeschaltet. Lief der Stromfluss im laufenden Betrieb von der Seite des ersten Knotenpunkts 101 zur Seite des zweiten Knotenpunkts 102, werden der zweite und dritte Halbleiterschalter 22, 23 angeschaltet, bei der anderen Stromrichtung der erste und vierte Halbleiterschalter 21, 24. Im Folgenden wird von einer Stromrichtung von der Seite des ersten Knotenpunkts 101 zur Seite des zweiten Knotenpunkts 102 ausgegangen.

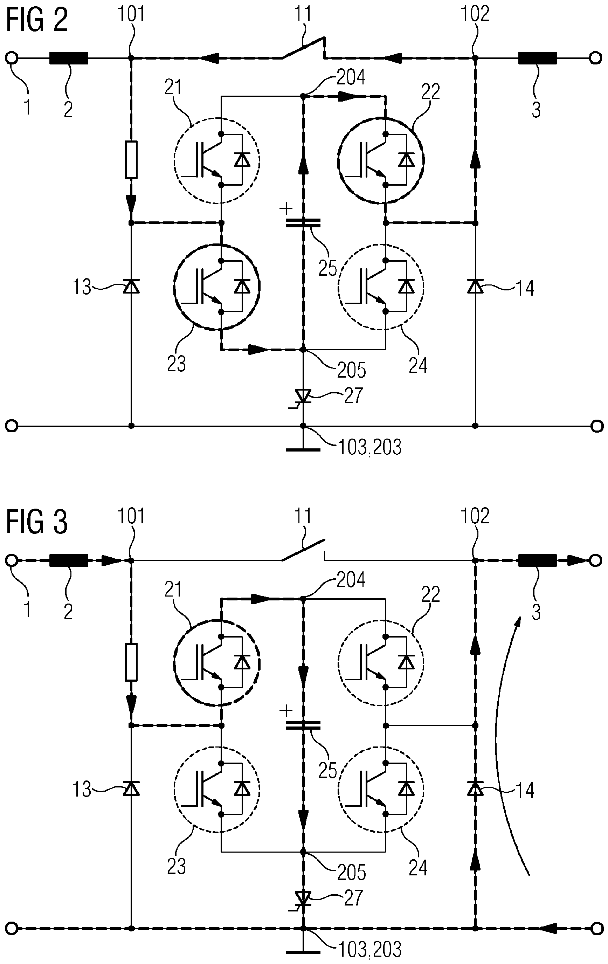

Durch das Anschalten der jeweiligen zwei Halbleiterschalter 21...24 ergibt sich ein Stromkreis, über den sich der Pulsstromkondensator 25 auf einem Weg über den zweiten Knotenpunkt 102, den mechanischen Schalter 11 und den ersten Knotenpunkt 101 entladen kann. Dadurch wird ein Strompuls erzeugt, der dem Strom aus dem laufenden Betrieb bzw. dem Kurzschlussstrom entgegengesetzt ist und somit einen Stromnulldurchgang erzeugt. Bei diesem Stromnulldurchgang erlischt ein eventuell vorhandener Lichtbogen im mechanischen Schalter 11. Hierdurch ist der Weg geöffnet, den Strom in den Halbleiterschaltern 21...24 abzuschalten. Der Stromkreis ist in Figur 2 markiert.

Der Fehlerstrom bzw. Betriebsstrom fließt an diesem Punkt durch die Dioden des ersten und vierten Halbleiterschalters 21, 24. Die Steuerung stellt nun sicher, dass der mechanische Schalter 11 komplett geöffnet ist. Danach wird zweckmäßig ein anderer Pfad für den Strom geschaffen.

Um einen Freilaufpfad für den Fehlerstrom zu schaffen, wird in der Folge der Thyristor 27 angeschaltet. Hierdurch ergeben sich Strompfade, die in Figur 3 dargestellt sind, für den Fall eines Stromflusses in Richtung vom ersten zum zweiten Knotenpunkt 101, 102. Die Anode der Diode des vierten Halbleiterschalters 24 wird durch das Anschalten des Thyristors 27 geerdet, wodurch diese Diode nicht mehr leitet. Danach führt ein Freilaufpfad für den abseits der Last getriebenen Strom vom ersten Knotenpunkt 101 über die Diode des ersten Halbleiterschalters 21, der selbst aber abgeschaltet ist, über den Pulsstromkondensator 25 und den Thyristor 27 zum dritten Knotenpunkt 103, also zum anderen Pol des Gleichspannungsnetzwerks 1. Der Freilaufpfad für den lastseitig getriebenen Strom führt über die Freilaufdiode 14 vom dritten zum zweiten Knotenpunkt 103, 102.

Der Pulsstromkondensator 25 wird nun geladen, bis die induktiv gespeicherte Energie abseits der Last aufgebraucht ist und der Thyristor in der Folge bei Ausbleiben von weiterem Stromfluss abschaltet.

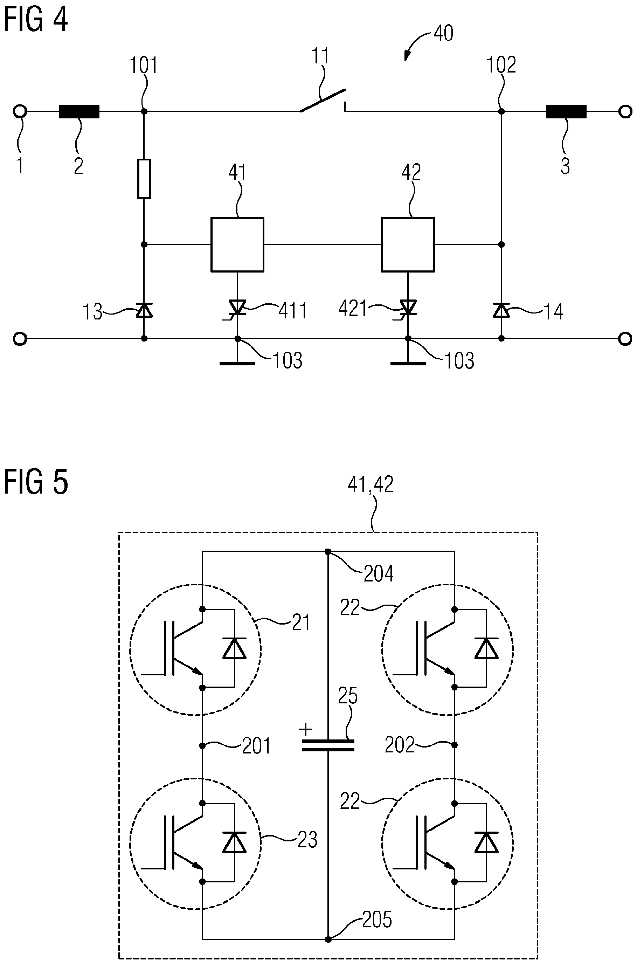

Figur 4 zeigt einen zweiten Gleichspannungsschalter 40, bei dem mehrere Pulsstrommodule 20 verwendet werden. Teile des Gleichspannungsschalters 40 bzw. der umliegenden Teile des Gleichspannungsnetzwerks 1, die gegenüber dem ersten Ausführungsbeispiel von Figur 1 unverändert sind, sind in Figur 4 mit denselben Bezugszeichen wie in Figur 1 versehen.

Im zweiten Strompfad, der im ersten Ausführungsbeispiel über das Pulsstrommodul 20 führt, sind nun im Gegensatz zum Ausführungsbeispiel gemäß Figur 1 zwei Pulsstrommodule 41, 42 angeordnet. Die Anbindung nach außen geschieht in den Pulsstrommodulen 41, 42 genauso wie im Pulsstrommodul 20 gemäß Figur 1, d.h. über den ersten, zweiten und dritten Modulknotenpunkt 201, 202, 203.

Nur der Übersicht halber umfassen die Pulsstrommodule 41, 42 in Figur 4 nicht den jeweils zugehörigen Thyristor 411, 421, während in Figur 1 das Pulsstrommodul 20 den Thyristor 27 einschließt. Nichtsdestotrotz ist jedes der Pulsstrommodule 41, 42 in Figur 4 mit einem jeweils eigenen Thyristor 411, 421 an den dritte Knotenpunkt, d.h. den nicht zu schaltenden Pol des Gleichspannungsnetzwerks 1 angebunden.

Der Aufbau jedes der Pulsstrommodule 41, 42 der Figur 4 ist vereinfacht in Figur 5 dargestellt und entspricht im Wesentlichen dem Pulsstrommodul 20 der Figur 1. Der erste Modulknotenpunkt 201 des ersten Pulsstrommoduls 41 ist mit dem ersten Knotenpunkt 101 verbunden und der zweite Modulknotenpunkt 202 des ersten Pulsstrommoduls 41 ist mit dem ersten Modulknotenpunkt 201 des zweiten Pulsstrommoduls 42 verbunden. Der zweite Modulknotenpunkt 202 des zweiten Pulsstrommoduls 42 ist mit dem zweiten Knotenpunkt 102 verbunden.

Durch eine derartige Serienschaltung oder eine Parallelschaltung der Pulsstrommodule 41, 42 kann die Belastbarkeit des Gleichspannungsschalters mit abschaltbarem Strom oder abzuschaltender Spannung eingestellt werden, wobei weiterhin Standardkomponenten im Bereich der Schalter und Kondensatoren verwendet werden können. Beispielsweise kann durch eine Serienschaltung mehrere Pulsstrommodule 41, 42 der Gleichspannungsschalter auf eine Betriebsspannung von 70 kV oder noch höhere Werte ausgelegt werden.

## Patentansprüche

1. Gleichspannungsschalter (10, 40) mit einem ersten und zweiten Knotenpunkt (101, 102) zur seriellen Einbindung in einen Pol (1) eines Gleichspannungsnetzes (1) und einem dritten Knotenpunkt (103) zum Anschluss an den anderen Pol des Gleichspannungsnetzes (1), weiterhin umfassend:
- einen zwischen dem ersten und zweiten Knotenpunkt (101, 102) angeordneten mechanischen Schalter (11),
- wenigstens ein zwischen dem ersten und zweiten Knotenpunkt (101, 102) parallel zum mechanischen Schalter (11) angeordnetes Pulsstrommodul (20, 41, 42),
wobei das Pulsstrommodul (20, 41, 42)
- drei Modulknotenpunkte (201, 202, 203) aufweist und der erste Modulknotenpunkt (201) mit dem ersten Knotenpunkt (101) und der zweite Modulknotenpunkt (202) mit dem zweiten Knotenpunkt (102) und der dritte Modulknotenpunkt (203) mit dem dritten Knotenpunkt (103) verbunden ist;
- vier Halbleiterschalter (21...24) umfasst, die als Brücke aus zwei Serien von je zwei der Halbleiterschalter (21...24) geschaltet sind, wobei die Potentialpunkte zwischen den Halbleiterschaltern (21...24) der beiden Serien dem ersten und zweiten Modulknotenpunkt (201, 202) entsprechen und die äußeren Enden der beiden Serien von je zwei der Halbleiterschaltern (21...24) paarweise zu einem vierten und fünften Modulknotenpunkt (204, 205) verbunden sind;
- einen Pulsstromkondensator (25) umfasst, der parallel zu den beiden Serien von je zwei der Halbleiterschalter (21...24) geschaltet ist; und
- ein schaltbares Halbleiterelement (27) zwischen dem fünften und dritten Modulknotenpunkt (205, 203) umfasst.

2. Gleichspannungsschalter (10, 40) nach Anspruch 1 mit einer Freilaufdiode (13) zwischen dem dritten und dem ersten Knotenpunkt (103, 101) und einer weiteren Freilaufdiode (14) zwischen dem dritten und dem zweiten Knotenpunkt (103, 102).

3. Gleichspannungsschalter (10, 40) nach Anspruch 1 mit einem in Serie zum Pulsstromkondensator (25) angeordnetem Widerstand (28) zur Ladestrombegrenzung.

4. Gleichspannungsschalter (10, 40) nach Anspruch 1 mit mehreren Pulsstrommodulen (41, 42), die mit ihren ersten und zweiten Modulknotenpunkten (201, 202) in Serie geschaltet sind und die Serie zwischen dem ersten und zweiten Knotenpunkt (101, 102) angeordnet ist.

5. Gleichspannungsschalter (10, 40) nach Anspruch 1, wobei der mechanische Schalter (11) eine Schaltzeit von weniger als 5 ms aufweist.

6. Gleichspannungsschalter (10, 40) nach Anspruch 1, bei dem das schaltbare Halbleiterelement (27) ein Thyristor (27) ist.

7. Gleichspannungsschalter (10, 40) nach Anspruch 1 mit einer Steuereinrichtung, die ausgestaltet ist, für ein Trennen der Gleichspannungsleitung den mechanischen Schalter (11) zu öffnen und zur Erzeugung eines dem Strom in der Gleichspannungsleitung gegengerichteten Strompulses zwei der vier Halbleiterschalter (21...24) einzuschalten.

8. Gleichspannungsschalter (10, 40) nach Anspruch 6, bei dem die Steuereinrichtung weiterhin ausgestaltet ist, beim Trennen der Gleichspannungsleitung das schaltbare Halbleiterelement (27) einzuschalten.

## Claims

1. DC voltage switch (10, 40) having a first and second node (101, 102) for series integration into a pole (1) of a DC voltage network (1) and having a third node (103) for connection to the other pole of the DC voltage network (1), further comprising:
- a mechanical switch (11) arranged between the first and second node (101, 102),
- at least one pulse-current module (20, 41, 42) arranged between the first and second node (101, 102) and in parallel with the mechanical switch (11),
wherein the pulse-current module (20, 41, 42)
- has three module nodes (201, 202, 203) and the first module node (201) is connected to the first node (101) and the second module node (202) is connected to the second node (102) and the third module node (203) is connected to the third node (103) ;
- comprises four semiconductor switches (21...24), which are connected as bridges composed of two series of in each case two of the semiconductor switches (21...24), wherein the potential points between the semiconductor switches (21...24) of the two series correspond to the first and second module node (201, 202) and the outer ends of the two series of in each case two of the semiconductor switches (21...24) are connected in pairs to a fourth and fifth module node (204, 205);
- comprises a pulse-current capacitor (25), which is connected in parallel with the two series of in each case two of the semiconductor switches (21...24); and
- comprises a switchable semiconductor element (27) between the fifth and third module node (205, 203).

2. DC voltage switch (10, 40) according to Claim 1, having a freewheeling diode (13) between the third and the first node (103, 101) and a further freewheeling diode (14) between the third and the second node (103, 102).

3. DC voltage switch (10, 40) according to Claim 1, having a resistor (28) arranged in series with the pulse-current capacitor (25) for the purpose of load current limitation.

4. DC voltage switch (10, 40) according to Claim 1, having a plurality of pulse-current modules (41, 42), which are connected in series with their first and second module nodes (201, 202) and the series is arranged between the first and second node (101, 102).

5. DC voltage switch (10, 40) according to Claim 1, wherein the mechanical switch (11) has a switching time of less than 5 ms.

6. DC voltage switch (10, 40) according to Claim 1, in which the switchable semiconductor element (27) is a thyristor (27).

7. DC voltage switch (10, 40) according to Claim 1, having a control device, which is configured to open the mechanical switch (11) for isolation of the DC voltage line and to switch on two of the four semiconductor switches (21...24) for the generation of a current pulse in the opposite direction to the current in the DC voltage line.

8. DC voltage switch (10, 40) according to Claim 6, in which the control device is further configured to switch on the switchable semiconductor element (27) upon isolation of the DC voltage line.

## Revendications

1. Interrupteur (10, 40) de tension continue, comprenant un premier et un deuxième point (101, 102) nodal pour l'insertion en série dans un pôle (1) d'un réseau (1) de tension continue et un troisième point (103) nodal de connexion à l'autre pôle du réseau (1) de tension continue, comprenant, en outre :
- un interrupteur (11) mécanique, monté entre le premier et le deuxième point (101, 102) nodal,
- au moins un module (20, 41, 42) de courant à impulsion, monté en parallèle à l'interrupteur (11) mécanique entre le premier et le deuxième point (101, 102) nodal,
dans lequel le module (20, 41, 42) de courant à impulsion
- a trois points (201, 202, 203) nodaux de module et le premier point (201) nodal de module est relié au premier point (101) nodal et le deuxième point (202) nodal de module au deuxième point (102) de module et le troisième point (203) nodal de module au troisième point (103) nodal ;
- comprend quatre interrupteurs (21...24) à semi conducteur, qui sont montés en pont, composés de deux séries de, respectivement, deux des interrupteurs (21...24) à semi-conducteur, les points de potentiel entre les interrupteurs (21...24) à semi-conducteur des deux séries correspondant au premier et au deuxième point (201, 202) nodal de module et les extrémités extérieures des deux séries de, respectivement, deux des interrupteurs (21...24) à semi-conducteur étant reliées par paire à un quatrième et cinquième point (204, 205) nodal de module ;
- comprend un condensateur (25) de courant à impulsion, qui est monté en parallèle aux deux séries de, respectivement, deux des interrupteurs (21...24) à semi-conducteur ; et
- comprend, entre le cinquième et le troisième point (205, 203) nodal de module, un élément (27) à semi-conducteur pouvant être commuté.

2. Interrupteur (10, 40) de tension continue suivant la revendication 1, comprenant une diode (13) de roue libre entre le troisième et le premier point (103, 101) nodal et une autre diode (14) de roue libre entre le troisième et le deuxième point (103, 102) nodal.

3. Interrupteur (10, 40) de tension continue suivant la revendication 1, comprenant, pour la limitation du courant de charge, une résistance (28) montée en série avec le condensateur (25) de courant à impulsion.

4. Interrupteur (10, 40) de tension continue suivant la revendication 1, comprenant plusieurs modules (41, 42) de courant à impulsion, qui sont montés en série avec leur premier et deuxième point (201, 202) nodal de module et la série est montée entre le premier et le deuxième point (101, 102) nodal.

5. Interrupteur (10, 40) de tension continue suivant la revendication 1, dans lequel l'interrupteur (11) mécanique a un temps de coupure de moins de 5 ms.

6. Interrupteur (10, 40) de tension continue suivant la revendication 1, dans lequel l'élément (27) à semi-conducteur pouvant être commuté est un thyristor (27).

7. Interrupteur (10, 40) de tension continue suivant la revendication 1, comprenant un dispositif de commande, qui est conformé pour ouvrir l'interrupteur (11) mécanique afin de séparer la ligne de tension continue et pour, afin de produire une impulsion de courant de sens contraire au courant dans la ligne de tension continue, mettre en circuit deux des quatre interrupteurs (21...24) à semi-conducteur.

8. Interrupteur (10, 40) de tension continue suivant la revendication 6, dans lequel le dispositif de commande est conformé, en outre, pour, lors de la séparation de la ligne de tension continue, mettre en circuit l'élément (27) à semi-conducteur pouvant être commuté.
